(19) Europäisches Patentamt
European Patent Office
Office européen des brevets

(11) Veröffentlichungsnummer: **0 290 657**
**A1**

(12) # EUROPÄISCHE PATENTANMELDUNG

(21) Anmeldenummer: **87107037.1**

(51) Int. Cl.⁴: **G01B 11/06 , G01N 21/59**

(22) Anmeldetag: **15.05.87**

(43) Veröffentlichungstag der Anmeldung:
**17.11.88 Patentblatt 88/46**

(84) Benannte Vertragsstaaten:
**CH DE FR GB IT LI NL**

(71) Anmelder: **LEYBOLD AKTIENGESELLSCHAFT**
**Wilhelm-Rohn-Strasse 25**
**D-6450 Hanau am Main(DE)**

(72) Erfinder: **Siegmund, Hans-Joachim**
**Fasanenweg 7**
**D-6113 Babenhausen(DE)**
Erfinder: **Schwiecker, Horst, Prof. Dr.**
**Wickramstrasse 435**
**D-1000 Berlin 22(DE)**

(74) Vertreter: **Zapfe, Hans, Dipl.-Ing.**
**Seestrasse 2 Postfach 30 04 08**
**D-6054 Rodgau-3(DE)**

(54) **Verfahren und Vorrichtung zur Messung der optischen Eigenschaften von dünnen Schichten.**

(57) Verfahren zur Messung der optischen Eigenschaften von dünnen Schichten während ihres Aufbaus in Vakuum-Beschichtungsanlagen (1). Dabei wird mindestens ein Meßobjekt (6) durch einen stationären Meßlichtstrahl (14) geführt und das Transmissionsverhalten des Meßobjekts (6) meßtechnisch ausgewertet. Durch Referenzmessungen in zeitlichen Abständen wird jeweils ein Bezugspunkt für die Messungen festgelegt. In der Bewegungsbahn des Meßobjekts (6) sind außerdem mindestens eine lichtundurchlässige Meßzone (7) und mindestens eine den Meßlichtstrahl nicht abschwächende Meßzone (8) angeordnet und in einer Recheneinheit (21) wird der Quotient aus dem Meßwert des Meßobjekts (6), vermindert um den Meßwert der undurchlässigen Meßzone (7), und aus dem Meßwert der nicht abschwächenden Meßzone (8), vermindert um den Meßwert der undurchlässigen Meßzone (7), gebildet.

FIG. 1

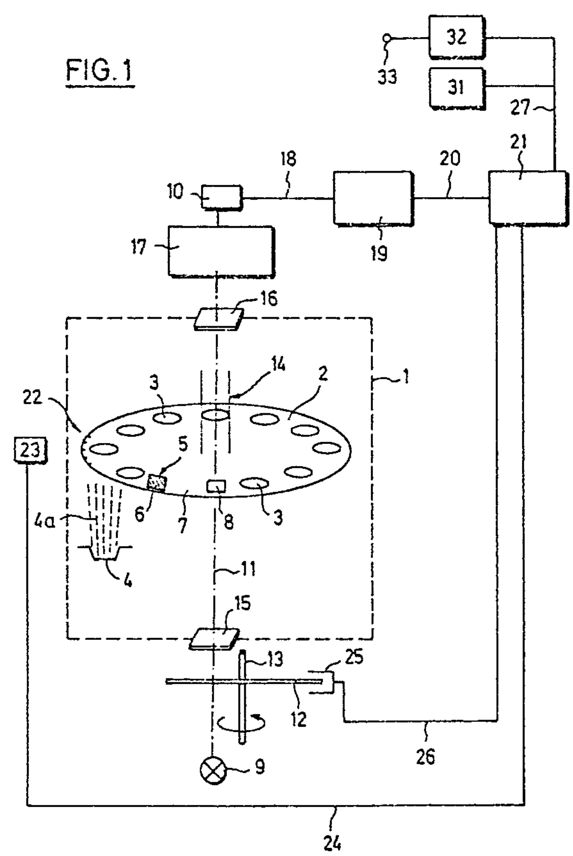

EP 0 290 657 A1

# "Verfahren und Vorrichtung zur Messung der optischen Eigenschaften von dünnen Schichten"

Die Erfindung betrifft ein Verfahren zur Messung der optischen Eigenschaften von dünnen Schichten während ihres Aufbaus in Vakuum-Beschichtungsanlagen, bei dem mindestens ein Meßobjekt durch einen stationären Meßlichtstrahl geführt wird, wobei das Transmissionsverhalten des Meßobjekts meßtechnisch ausgewertet wird, und bei dem durch Referenzmessungen in zeitlichen Abständen jeweils ein Bezugspunkt für die Messungen festgelegt wird.

Durch die DE-OS 26 27 753 ist es bekannt, einen stationären, von einer einzigen Meßlichtquelle ausgehenden Meßlichtstrahl zu verwenden und von diesem einen Referenzlichtstrahl abzuspalten. Das Meßobjekt (ein Testglas) ist dabei während der Messung stationär in der Mitte eines Substrathalters angeordnet, wobei der durchgehende Teil des Meßlichts von einem Fotoempfänger erfaßt wird. Ein zweiter Fotoempfänger ist dem abgespaltenen Referenzlichtstrahl zugeordnet, und aus den Ausgangssignalen der beiden Fotometer wird nach entsprechender Verstärkung der Quotient gebildet. Während es hierdurch gelungen ist, Helligkeitsschwankungen der Meßlichtquelle weitgehend zu kompensieren, bleiben unterschiedliche Veränderungen in den beiden Strahlengängen sowie die Einflüsse unterschiedlicher Kennlinien bzw. unterschiedlicher Arbeitspunkte auf den Kennlinien der beiden Fotoempfänger bestehen. Dies hat negative Auswirkungen auf die Genauigkeit der Meßergebnisse.

Es ist weiterhin bekannt, einen abgespaltenen Referenzlichtstrahl nach mehrfacher Umlenkung und Reflexion an Spiegelsystemen dem gleichen Fotoempfänger zuzuleiten wie den eigentlichen Meßlichtstrahl. Dies geschieht aufgrund eines Zerhackervorgangs alternierend, so daß durch eine entsprechende Abfrage am Ausgang des Fotoempfängers durch eine Auswerteschaltung die dadurch gebildeten, getrennten Impulsfolgen im Hinblick auf den gewünschten Kompensationseffekt ausgewertet werden können. Die Spiegelsysteme verhindern jedoch den baulichen Aufwand erheblich, und sie unterliegen auch zeitlichen Veränderungen der Reflexionswerte, so daß der angestrebte Kompensationseffekt stets von solchen Fehlern begleitet ist.

Durch die DE-OS 31 35 444 ist es bekannt, auf einen Referenzlichtstrahl zu verzichten und durch eine aufwendige elektronische Schaltung mit Zwischenspeicherung von Meßwerten und Verstärkungsfaktoren das gesamte Spektrum des Meßbereichs in Form von Absolutwerten darzustellen. Die Messungen erfolgen jedoch wiederum an einem zumindest während der Messung feststehenden Testglas, dessen Position im Hinblick auf den von einer Quelle ausgehenden Strom des Beschichtungsmaterials üblicherweise nicht mit der Position der zu beschichtenden Substrate übereinstimmt, so daß der Schichtaufbau auf den Substraten und auf dem Testglas nicht notwendigerweise übereinstimmt. Auch hier muß von Zeit zu Zeit eine Eichung bzw. Kalibrierung durchgeführt werden. Dies geschieht einerseits durch die Messung eines ungeschwächten, d.h. durch keine feste Materie hindurchgehenden Meßlichtstrahl, andererseits durch vollständige Unterbrechung des Meßlichtstrahls durch Einschieben eines undurchsichtigen Körpers (O-Blende) in den Strahlengang. In dem zuerst genannten Fall treffen 100 % der Intensität des Meßlichtstrahls, in dem zuletzt genannten Fall 0 % der Intensität auf den Fotoempfänger auf. Während des Schichtaufbaus ist jedoch eine solche Eichung nicht ohne weiteres durchzuführen.

Der Erfindung liegt daher die Aufgabe zugrunde, ein Verfahren der eingangs beschriebenen Gattung anzugeben, das mit einem einzigen stationären Strahlengang auskommt, bei dem das bewegliche Meßobjekt nacheinander durch den Strom des Beschichtungsmaterials und durch den Meßlichtstrahl geführt wird, und bei dem nach jeder Messung automatisch eine Kompensation aller möglichen Einflüsse auf das Meßergebnis erfolgt.

Die Lösung der gestellten Aufgabe erfolgt bei dem eingangs angegebenen Verfahren erfindungsgemäß dadurch, daß in der Bewegungsbahn des Meßobjekts außerdem mindestens eine lichtundurchlässige Meßzone und mindestens eine den Meßlichtstrahl nicht-abschwächende Meßzone angeordnet sind, und daß in einer Recheneinheit der Quotient aus dem Meßwert des Meßobjekts, vermindert um den Meßwert der undurchlässigen Meßzone, und aus dem Meßwert der nicht-abschwächenden Meßzone, vermindert um den Meßwert der undurchlässigen Meßzone, gebildet wird, und daß der Quotient als Transmissionswert des beschichteten Meßobjekts ausgewertet wird.

Die "lichtundurchlässige Meßzone" kann dabei durch jeden beliebigen festen Körper gebildet werden, der vorübergehend und für endliche Zeit den Strahlengang vollständig sperrt. Sofern das Meßobjekt in einem plattenförmigen oder kalottenförmigen Substrathalter aus Metall mit mehreren Durchbrechungen für die Aufnahme einzelnen Substrate angeordnet wird, können die Stege zwischen den Durchbrechungen die "lichtundurchlässige Meßzone" bilden.

Die den Meßlichtstrahl "nicht-abschwächende Meßzone" kann in einfachster Weise durch eine Durchbrechung im Substrathalter gebildet werden, in der weder ein Meßobjekt, noch ein Substrat

angeordnet ist.

Auf diese Weise werden am Ende des einzigen Strahlengangs, d.h. am Fotoempfänger zwei Meßwerte gebildet, die stets 0 % bzw. 100 % der Intensität des Meßlichtstrahls darstellen. Der dritte Wert, nämlich der Meßwert des Meßobjekts selbst, liegt - jedenfalls im Bereich eines transparenten Meßobjekts - zwischen den beiden Grenzwerten. Die in der Recheneinheit durchgeführte Rechenoperation entspricht nun der Beziehung:

$$T = \frac{I_M - I_0}{I_{100} - I_0} \cdot 100\ (\%).$$

Dabei ist:

$I_M$ = der vom Fotoempfänger erfaßte vom Meßobjekt durchgelassene Anteil des Meßlichtstrahls

$I_0$ = die vom Fotoempfänger erfaßte Strahlungsintensität bei völliger Sperrung des Meßlichtstrahls

$I_{100}$ = die vom Fotoempfänger erfaßte Strahlung bei völliger Freigabe des Meßlichtstrahls.

Der Wert $I_0$ ist in der Regel sehr klein, wenn nicht gar 0. Allenfalls können hier Streulichteffekte bzw. Lichtstrahlungen erfaßt werden, die beim Betrieb be stimmter Beschichtungsquellen erzeugt werden. In jedem Fall ändert sich der Meßwert $I_M$ proportional mit dem maximalen Intensitätswert $I_{100}$. Jegliche Schwankung der Intensität der Meßlichtquelle wirkt sich dabei auf Zähler und Nenner des genannten Quotienten aus, so daß dieser Einfluß in der kürzest möglichen Zeit rechnerisch kompensiert wird. Weitere Abweichungen treten nicht auf, da es weder getrennte Strahlengänge noch getrennte Schaltkreise mit unterschiedlichem Drift-Verhalten gibt. Die rechnerische Kompensation erfolgt auch in der kürzest möglichen Zeit. Wenn nämlich ein Substrathalter in Form einer um ihre Achse rotierenden Kreisscheibe oder Kalotte verwendet wird, an deren Rand sowohl Ausnehmungen für Substrate als auch eine Ausnehmung für das Meßobjekt sowie die erfindungsgemäßen Meßzonen angeordnet sind, dann laufen die Substrate, das Meßobjket und die genannten Meßzonen nacheinander mehrfach durch den Strom des Beschichtungsmaterials, so daß die Gesamtschicht aus zahlreichen Einzelschichten aufgebaut wird. Nach jedem einzelnen Durchgang durch den Strom des Beschichtungsmaterials wird jedoch ein Meßwert gewonnen, bei dem automatisch sämtliche Fehlereinflüsse, soweit sie überhaupt noch möglich sind, kompensiert sind.

Es versteht sich, daß jegliche Kondensation von Beschichtungsmaterial in in der lichtundurchlässigen Meßzone keinen Einfluß auf das zugehörige Meßsignal hat, und daß die durch eine Durchbrechung im Substrathalter gebildete nicht abschwächende Meßzone wegen des ungehinderten Materialdurchtritts keine Kondensation bewirken kann, so daß auch hier durch den Beschichtungsvorgang keine Beeinflussung des zugehörigen Meßsignals erfolgen kann.

Die Erfindung ist nicht auf die Verwendung rotierender Substrathalter beschränkt, sondern vielmehr auch bei linear verschiebbaren Substrathaltern anwendbar, die nacheinander an unterschiedlichen Beschichtungsquellen vorbei bewegbar sind oder gegenüber einer oder mehreren Beschichtungsquellen oszillierend bewegt werden.

Als Meßobjekt kann dabei eines der Substrate verwendet werden oder ein besonderes Testglas; es können aber auch sämtliche Substrate nacheinander als Meßobjekte dienen, ein Fall, der jedoch die Ausnahme bleiben wird. Substrate und/oder Meßobjekte werden dabei alternierend durch den Strom des Beschichtungsmaterials geführt (oder die Ströme von Beschichtungsmaterialien geführt, wenn es sich um eine Mehrstoffbeschichtung handelt), und durch den Meßlichtstrahl, so daß Änderungen in der Dichte des von der Beschichtungsquelle ausgehenden Stoffstroms extrem kurzfristig erfaßt und auch ausgeregelt werden können, wenn man das erfindungsgemäße Meßverfahren zur Istwert-Gewinnung bei einem Regelverfahren verwendet, das beispielsweise auf die Leistungsregelung der Quelle des Beschichtungsmaterials Einfluß nimmt.

Die Erfindung betrifft auch eine Vorrichtung zur Durchführung des eingangs angegebenen Verfahrens mit einer Vakuumkammer und einem darin beweglich angeordneten Substrathalter mit Einrichtungen zur Halterung mindestens eines Meßobjekts und zur Bewegung des Meßobjekts entlang einer Bewegungsbahn, mit einer Beschichtungsquelle, einer Meßlichtquelle und einem mit der Meßlichtquelle durch einen Strahlengang verbundenen Meßlichtempfänger, wobei die Bewegungsbahn des Meßobjekts nacheinander durch den von der Beschichtungsquelle ausgehenden Materialstrom und den Strahlengang verläuft.

Als Beschichtungsquellen können dabei beheizbare Verdampfer, Zerstäubungskatoden, Gaszuführungseinrichtungen in Verbindung mit Energiequellen für die Polymerisation von Monomeren auf den Substraten etc. verwendet werden.

Zur Lösung der gleichen Aufgabe wird bei der vorstehend angegebenen Vorrichtung erfindungsgemäß vorgeschlagen, daß in dem Substrathalter außer dem Meßobjekt mindestens eine lichtundurchlässige Meßzone und mindestens eine den Meßlichtstrahl nicht abschwächende Meßzone angeordnet sind, daß der Substrathalter für die Meldung der Stellungen des Meßobjekts und der Meßzonen je einen Signalgeber besitzt und daß die Ausgänge des Fotoempfängers und der Signalempfänger einer Recheneinheit aufgeschaltet sind, in der der Quotient aus dem Meßwert des Meßobjekts, vermindert um den Meßwert der undurchlässigen Meßzone, und aus dem Meßwert der nicht abschwächenden Meßzone, vermindert um den Meßwert der undurchlässigen Meßzone, gebildet wird, und in der der Quotient als Transmissionswert des beschichteten Meßobjekts auswertbar ist.

Ein Ausführungsbeispiel des Erfindungsgegenstandes wird nachfolgend anhand der Figuren 1 bis 3 näher beschrieben.

Es zeigen:

Figur 1 eine schematische Darstellung der Vorrichtung in Verbindung mit einem Blockshaltbild zur Signalverarbeitung,

Figure 2 eine Draftsicht auf einen drehbaren Substrathalter und

Figur 3 ein Diagramm einer Signalfolge, die beim Durchgang von Meßobjekt, lichtundurchlässiger Meßzone und nicht abschwächender Meßzone durch den Meßlichtstrahl am Ausgang des Fotoempfängers gebildet wird.

In Figur 1 ist gestrichelt der Umriß einer Vakuumkammer 1 dargestellt, in der mittels nicht gezeigter Vakuumpumpen das für den Beschichtungsvorgang erforderliche Betriebsvakuum aufrechterhalten wird. In der Vakuumkammer 1 ist ein um eine senkrechte Achse drehbarer Substrathalter 2 in Form einer Kreisscheibe angeordnet, in deren Randbereich eine Anzahl von Ausnehmungen 3 für die Unterbringung von Substraten angeordnet ist. Diese Substrate haben sämtlich die gleiche (kreisförmige) Bewegungsbahn, die über die Mitte einer unter dem Substrathalter 2 angeordneten Quelle 4 für das Beschichtungsmaterial hinweg verläuft. In der gleichen Bewegungsbahn wie die Ausnehmungen 3 liegen auch eine weitere Ausnehmung 5 für das Meßobjekt 6 ein lichtundurchlässige Meßzone 7 und eine den Meßlichtstrahl nicht abschwächende Meßzone 8. Wie bereits weiter oben ausgeführt wurde, besteht das Meßobjekt 6 zweckmäßig aus einem Testglas, das durch eine planparallele Glascheibe gebildet wird, die Meßzone 7 aus einem massiven Flächenteil (Steg) des Substrathlaters 2 und die Meßzone 8 aus einer offenen Durchbrechung bzw. weiteren Ausnehmung im Substrathalter 2.

Die optische Meßvorrichtung, das sogenannte Fotometer, enthält eine Meßlichtquelle 9 und einen Fotoempfänger 10, zwischen denen sich ein im wesentlichen geradliniger, senkrechter Strahlengang 1 erstreckt, dem der von der Meßlichtquelle 9 ausgehende Meßlichtstrahl folgt. Auch der Strahlengang 11 ist in der Bewegungsbahn der Substrate, des Meßobjekts und der Meßzonen angeordnet und infolgedessen exzentrisch zur Drehachse des Substrathalters angeordnet.

Zur Kompensation von Umgebungseinflüssen wird der Meßlichtstrahl durch eine Zerhackerscheibe 12, die um eine Achse 13 rotiert, in einzelne Lichtimpulse zerlegt. Der Meßlichtstrahl 14, von dem nur eine Teillänge gezeigt ist, tritt durch ein erstes Fenster 15 in die Vakuumkammer 1 ein und verläßt diese wieder durch ein zweites Fenster 16.. In einem Monochromator 17 wird aus dem Spektrum des Meßlichtstrahls eine bestimmte Frequenz bzw. ein enger Frequenzbereich ausgewählt. Durch Verstellung des Monochromators 17, der als Filter, Beaugungsgitter oder Prisma ausgeführt sein kann, können die optischen Eigenschaften über das gesamte Spektrum der Meßlichtquelle untersucht bzw. gemessen werden. Es ist darauf zu achten, daß die Quelle 4 in einem solchen Abstand seitlich vom Meßlichtstrahl 14 angeordnet ist, daß das Fenster 16 nicht vom Beschichtungsmaterial getroffen wird.

Die Ausgangssignale des Fotoempfängers 10 werden über eine Leitung 18 einem Interface 19 zugeführt, in dem eine Analog-Digital-Umsetzung erfolgt. Das Ausgangssignal des Interface 19 wird über eine Leitung 20 einer Zentraleinheit 21 zugeführt, die einen digitalen Lock-In-Verstärker und eine Recheneinheit enthält, in der die erfindungsgemäße Auswertung der Meßsignale erfolgt.

Um die erforderliche Synchronisation bzw. Triggerung zu erreichen, besitzt der Substrathalter eine Reihe hier nur schematisch dargestellter Signalgeber 22 für die Stellungsmeldung des Meßobjekts 6 und der Meßzonen 7 und 8 in Verbindung mit einem Signalempfänger 23. Dessen Ausgang wird über eine Leitung 24 gleichfalls der Zentraleinheit 21 zugeführt, in der eine zeitliche Zuordnung der Ausgangssignale des Fotoempfängers 10 zum Meßobjekt 6 bzw. zur den Meßzonen 7 und 8 erfolgt. Bei den Signalgebern 22 kann es sich beispielsweise um magnetische Einrichtungen handeln, auf deren Vorbeibewegung der Signalempfänger 23 anspricht, der beispielsweise als Reed-Relais ausgeführt sein kann. Auch die Zerhackerscheibe 12 ist in ihrem Randbereich mit nicht näher bezeichneten Signalgebern versehen, die auf einen weiteren Signalempfänger 25 einwirken, der über eine Leitung 16 mit der Zentraleinheit 21 verbunden ist.

Die Wirkungsweise der Fotometeranordnung wird anhand der Figuren 2 und 3 näher erläutert: Wenn der Substrathalter 2 sich um seine Achse 2a dreht, dann gelangen nacheinander die Ausnehmungen 3 mit den Substraten, das Meßobjekt 6, die lichtundurchlässige Meßzone 7 und die nicht abschwächende Meßzone 8 in den Strahlengang 11 des Fotometers. Die Bewegungsbahn dieser Elemente wird durch einen Kreis definiert, der durch die Mittelpunkte der genannten Elemente

verläuft. Abgesehen von den Meßsignalen, die durch die Substrate erzeugt werden und die durch die weiter oben beschriebene Triggerung nicht erfaßt werden, entsteht bei der Drehung des Substrathalters 2 in Richtung des Pfeils 2b eine erste Folge 28 von Rechteckimpulsen, deren Höhe der Intensität $I_M$ des vom Meßobjekt 6 durchgelassenen Anteils des Meßlichtstrahls entspricht. Die nachfolgend durch den Meßlichtstrahl geführte lichtundurchlässige Meßzone 7 erzeugt am Ausgang des Fotoempfängers 10 ein Meßsignal 29 mit einem extrem niedrigen Pegel $I_0$. Dieses Meßsignal 29 besteht nicht aus einer Impulsfolge, da die Wirkung der Zerhackerscheibe 12 durch die vollständige Sperrung des Meßlichtstrahls ausgeschaltet wird. Dem Meßsignal 29 folgt eine zweite Folge von Rechteckimpulsen, deren Höhe der ungeschwächten Intensität des Meßlichtstrahls $I_{100}$ entspricht. Die Frequenz der Impulse entspricht der Drehzahl der Zerhackerscheibe 12 multipliziert mit der Anzahl der in der Zerhackerscheibe 12 angeordneten Durchbrechungen. Aus den Impulsfolgen sowie aus dem Meßsignal 29 wird in der Zentraleinheit 21 der gewünschte Meßwert gebildet, der über eine Leitung 27 einer Anzeigeeinheit 31 oder einem Regler 32 zugeführt werden kann, wobei der Regler 32 einen Ausgang 33 besitzt, über den in an sich bekannter Weise beispielhaft eine Leistungssteuerung der Quelle 4 herbeigeführt werden kann. Es ist auch möglich, uber den Ausgang 33 eine Unterbrechung bzw. Abschaltung des Beschichtungsvorganges herbeizuführen, indem Beispielsweise eine Blende in den von der Quelle 4 ausgehenden Strom 4a des Beschichtungsmaterials geschwenkt wird.

## Ansprüche

1. Verfahren zur Messung der optischen Eigenschaften von dünnen Schichten während ihres Aufbaus in Vakuum-Beschichtungsanlagen, bei dem mindestens ein Meßobjekt durch einen stationären Meßlichtstrahl geführt wird, wobei das Transmissionsverhalten des Meßobjekts meßtechnisch ausgewertet wird, und bei dem durch Referenzmessungen in zeitlichen Abständen jeweils ein Bezugspunkt für die Messungen festgelegt wird, dadurch gekennzeichnet, daß in der Bewegungsbahn des Meßobjekts außerdem mindestens eine lichtundurchlässige Meßzone und mindestens eine den Meßlichtstrahl nicht abschwächende Meßzone angeordnet sind, und daß in einer Recheneinheit der Quotient aus dem Meßwert des Meßobjekts, vermindert um den Meßwert der undurchlässigen Meßzone, und aus dem Meßwert der nicht abschwächenden Meßzone, vermindert um den Meßwert der undurchlässigen Meßzone, gebildet wird, und daß der Quotient als Transmissionswert des beschichteten Meßobjekts ausgewertet wird.

2. Verfahren nach Anspruch 1, **dadurch gekennzeichnet**, daß die Bewegung des Meßobjekts und der Meßzonen und die Quotientenbildung in der Recheneinheit durch je ein Triggersignal synchronisiert werden.

3. Vorrichtung zur Durchführung des Verfahrens nach Anspruch 1 mit einer Vakuumkammer und einem darin beweglich angeordneten Substrathalter mit Einrichtungen zur Halterung mindestens eines Meßobjekts und zur Bewegung des Meßobjekts entlang einer Bewegungsbahn, mit einer Beschichtungsquelle, einer Meßlichtquelle und einem mit der Meßlichtquelle durch einen Strahlengang verbundenen Meßlichtempfänger, wobei die Bewegungsbahn des Meßobjekts nacheinander durch den von der Beschichtungsquelle ausgehenden Materialstrom und den Strahlengang verläuft, **dadurch gekennzeichnet**, daß in dem Substrathalter (2) außer dem Meßobjekt (6) mindestens eine lichtundurchlässige Meßzone (7) und mindestens eine den Meßlichtstrahl (14) nicht abschwächende Meßzone (8) angeordnet sind, daß der Substrathalter (2) für die Meldung der Stellungen des Meßobjekts und der Meßzonen je einen Signalgeber (22) besitzt und daß die Ausgänge des Fotoempfängers (10) und der Signalempfänger (22) einer Recheneinheit (21) aufgeschaltet sind, in der der Quotient aus dem Meßwert des Meßobjekts, vermindert um den Meßwert der undurchlässigen Meßzone, und aus dem Meßwert der nicht abschwächenden Meßzone, vermindert um den Meßwert der undurchlässigen Meßzone, gebildet wird, und in der der Quotient als Transmissionswert des beschichteten Meßobjekts (6), auswertbar ist.

FIG. 1

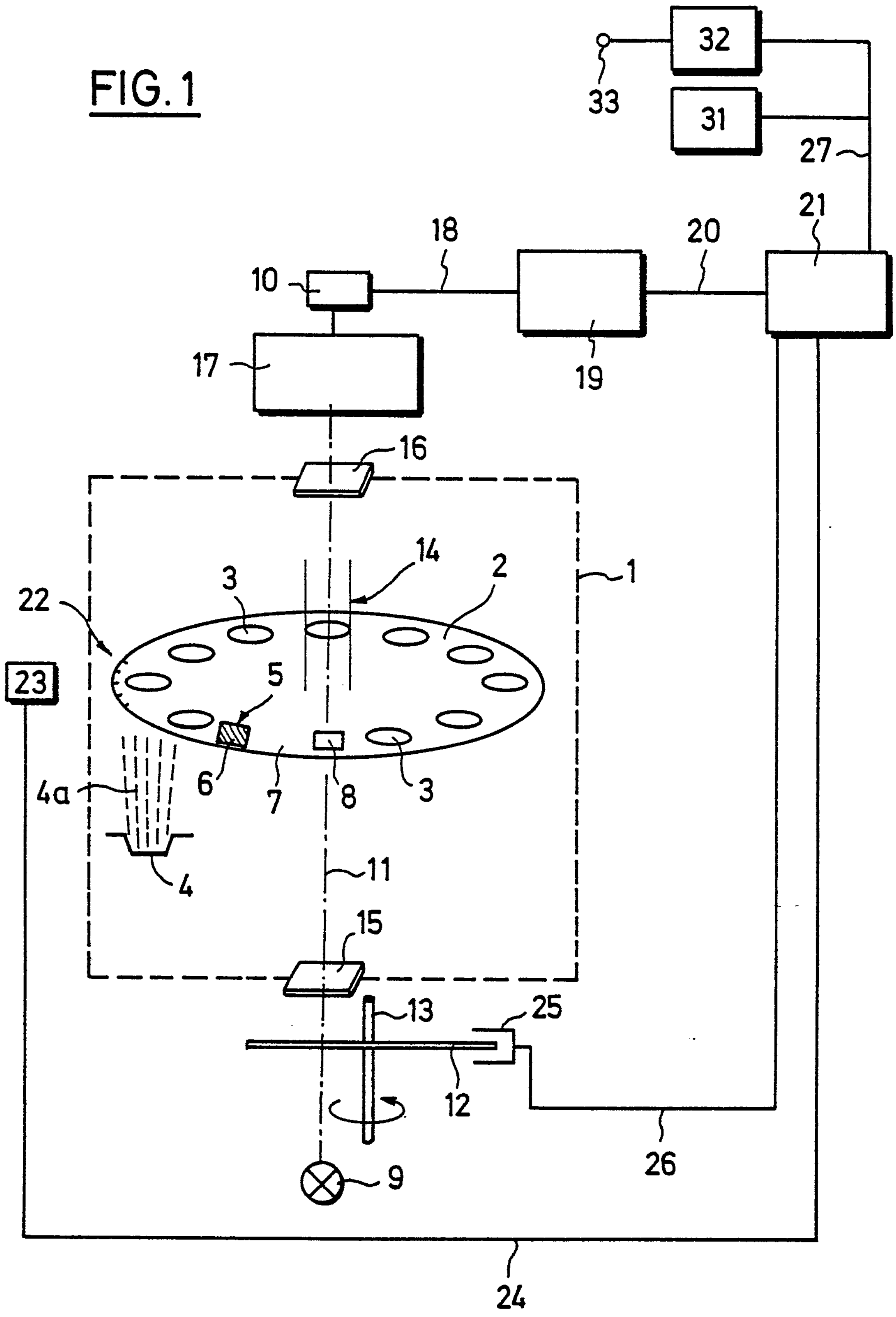
32
31
33
27
21
18
20
10
19
17
16
14
2
3
1
22
23
5
6
7
8
3
4a
4
11
15
13
25
12
26
9
24

FIG. 2

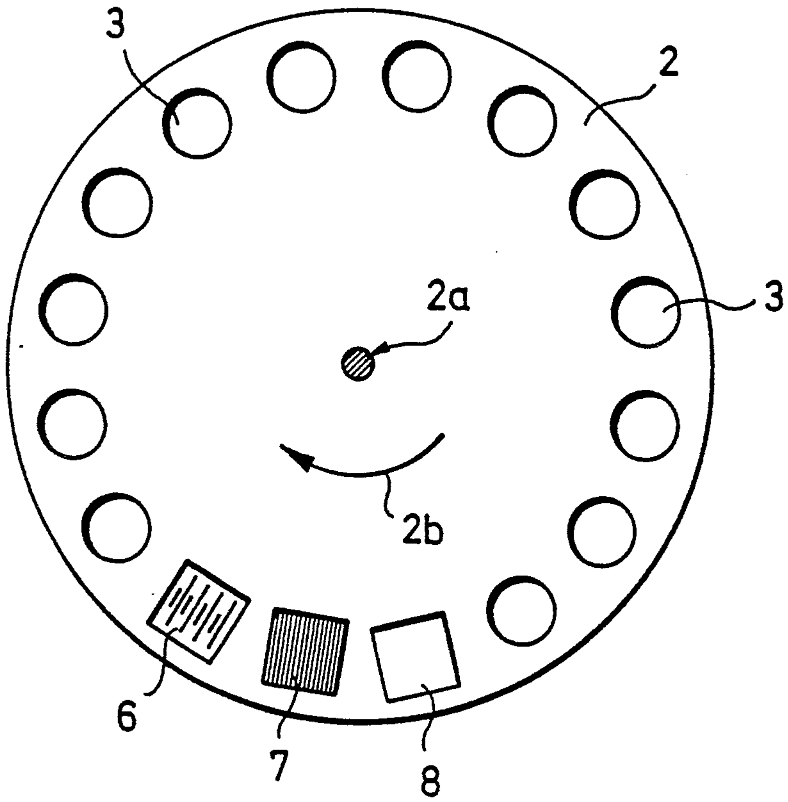


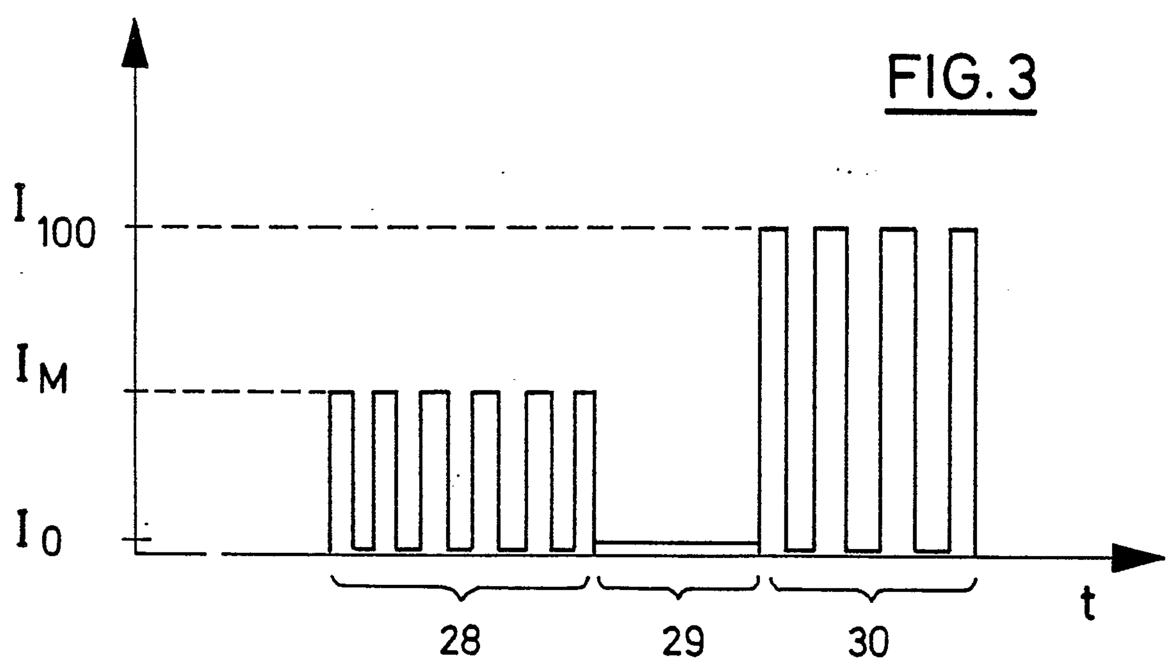


FIG. 3

Europäisches Patentamt

# EUROPÄISCHER RECHERCHENBERICHT

Nummer der Anmeldung

EP 87 10 7037

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-A-3 135 443 (LEYBOLD-HERAEUS GMBH) * Ansprüche 1-5 * --- | 1,3 | G 01 B 11/06<br>G 01 N 21/59 |
| Y,D | DE-A-2 627 753 (LEYBOLD-HERAEUS GMBH & CO. KG) * Ansprüche 1-12 * --- | 1,2 | |
| Y | DE-A-3 234 534 (KIEVSKOE NAUCNO-PROIZVODSTVENNOE OB EDINENIE ANALITPRIBOR) * Seiten 17-22 * --- | 2 | |
| Y | US-A-3 917 957 (R.W. ANSEVIN et al.) * Spalten 3-12 * --- | 3 | |
| A | GB-A-2 029 017 (LESLIE HOLLAND) * Ansprüche 1-11 * ----- | 1,3 | |
| | | | **RECHERCHIERTE SACHGEBIETE (Int. Cl.4)** |
| | | | G 01 B 11/00<br>G 01 M 11/00<br>G 01 N 21/00 |

Der vorliegende Recherchenbericht wurde für alle Patentansprüche erstellt

| Recherchenort | Abschlußdatum der Recherche | Prüfer |
|---|---|---|
| BERLIN | 28-12-1987 | DIETRICH A. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)